# EUROPEAN PATENT SPECIFICATION

(11) **EP 2 408 032 B1**
(45) Date of publication and mention of the grant of the patent: **04.05.2016**
(21) Application number: 10750703.0
(22) Date of filing: 01.03.2010
(51) Int. Cl.: H01L 35/34, H01L 35/08, H02N 11/00

(54) **METHOD OF PRODUCING THERMOELECTRIC CONVERSION DEVICE**
VERFAHREN ZUR HERSTELLUNG EINES THERMOELEKTRISCHEN WANDLERS
PROCÉDÉ DE FABRICATION D'UN DISPOSITIF DE CONVERSION THERMOÉLECTRIQUE

(30) Priority: 12.03.2009 JP 2009059267
(43) Date of publication of application: 18.01.2012
(73) Proprietor: Kabushiki Kaisha Atsumitec, Shizuoka 431-0192 (JP); National Institute of Advanced Industrial Science and Technology, Tokyo 100-8921 (JP)
(72) Inventor: UCHIYAMA, Naoki, Hamamatsu-shi Shizuoka 431-0192 (JP); KUBO, Kazuya, Hamamatsu-shi Shizuoka 431-0192 (JP); MIKAMI, Masashi, Nagoya-shi Aichi 463-8560 (JP); KOBAYASHI, Keizo, Nagoya-shi Aichi 463-8560 (JP); NISHIO, Toshiyuki, Nagoya-shi Aichi 463-8560 (JP)
(74) Representative: advotec.
(86) International application number: PCT/JP2010/053242
(87) International publication number: WO 2010/103949

(56) References cited:
- EP-A2- 0 821 417
- JP-A- 5 055 640
- JP-A- H1 065 222
- JP-A- H1 074 986
- JP-A- 10 065 222
- JP-A- H06 268 264
- JP-A- 2003 332 644
- JP-A- 2004 031 696
- JP-A- 2006 135 259
- JP-A- 2006 332 443
- JP-A- 2007 109 942

## Description

### Technical Field

This invention relates to a method for producing a thermoelectric module, and more specifically, a method for producing a thermoelectric module in which thermoelectric elements interposed between electrodes are bonded to the electrodes by passing an electric current through the electrodes and the thermoelectric elements.

### Background Art

A thermoelectric module using the Seebeck effect has a property of converting thermal energy into electric energy. This property can be used to convert thermal energy discharged in industrial or household processes or from moving vehicles into effective electric energy. The thermoelectric modules are therefore attracting attention as an environment-conscious energy-saving technology.

Such thermoelectric module is commonly constructed by bonding a plurality of thermoelectric elements (p-type and n-type) to electrodes. The thermoelectric element is made as described below. First, a material to be sintered is packed in a space defined by cylindrical dies and an upper and a lower punches forming a pair. Then, by passing an electric current (pulsed electric current) directly through the material while pressing the material vertically with the punches, a thermoelectric element is obtained. Use of Joule heating by supplying an electric current in this manner, instead of heating a sintering furnace, enables heating of limited areas, resulting in a reduced sintering time and more uniform temperature in heating.

Such sintering with pulsed electric current is disclosed in patent document 1, for example, and a method for producing a thermoelectric module by bonding thermoelectric elements to electrodes is disclosed in patent document 2 (see FIG. 14 of patent document 2, in particular), for example.

In the bonding of p-type and n-type thermoelectric elements to electrodes, however, there are observed such cases that variations in height of thermoelectric elements result in variations in bond, specifically strength of bond, for example, between the respective thermoelectric elements and their associated electrodes. Such non-uniform bond easily leads to separation of one or more of the thermoelectric elements from their associated electrodes. If one or more of the thermoelectric elements have completely or partly separated from their associated electrodes so that they are no longer bonded or imperfectly bonded thereto, it results in non-uniform interfacial thermal and electrical resistances at the interface between the thermoelectric elements and the electrodes.

In order to bond a plurality of thermoelectric elements to electrodes, an electric current is supplied to pass through the thermoelectric elements and electrodes while pressing the thermoelectric elements vertically. If the thermoelectric elements have variations in height and one or more of the thermoelectric elements imperfectly contact their associated electrodes, the interfacial electrical resistance at the interface between the thermoelectric elements and the electrodes is great at the locations of such imperfectly-contacting thermoelectric elements. Therefore, the parts having such great electrical resistance generate heat, which causes increase in temperature locally. Such local temperature increase may affect the thermoelectric properties of the resulting thermoelectric module. Further, the gaps left between such imperfectly-contacting thermoelectric elements and the electrodes lead to concentration of load in the pressing process, and thus, uniform application of load is not achieved.

From document JP 2003 332644 a method for producing a thermoelectric module is known comprising the steps of arranging electrodes on both sides of a plurality of thermoelectric elements bonding the electrodes to the plurality of thermoelectric elements by supplying an electric current to pass through the electrodes and the thermoelectric elements while pressing the electrodes and the thermoelectric elements.

### Prior-art Document

### Patent Document

Patent document 1: Japanese Unexamined Patent Publication No. 2003-46149
Patent document 2: Japanese Unexamined Patent Publication No. 2004-221464

### Summary of the Invention

### Problem to be Solved by the Invention

The present invention is conceived to solve the problems in the aforementioned prior art, and an object of the present invention is to provide a method for producing a thermoelectric module in which thermoelectric elements can be appropriately bonded to electrodes even if the thermoelectric elements have variations in height.

### Means for Solving the Problem

In order to achieve the above object, a method for producing a thermoelectric module according to claim 1 is provided.

Preferably, the intermediate layer may be made from a paste-form bonding material containing the metal powder.

Specifically, the metal powder may be powder of copper or nickel.

### Effect of the Invention

In the method for producing a thermoelectric module according to the present invention, an intermediate layer containing an electroconductive metal powder and being deformable is provided between each of the electrodes and the thermoelectric element to be bonded thereto. Thus, even if the thermoelectric elements have variations in height, the intermediate layers compensate for those variations in height by each deforming according to the size of a gap between its associated electrode and thermoelectric element. As a result, uniform bond is established between all the thermoelectric elements and their associated electrodes. The intermediate layers containing the electroconductive metal powder can provide good electrical conductivity between the electrodes and the thermoelectric elements. Consequently, it is possible to produce a thermoelectric module by supplying an electric current and applying pressure without problems.

Forming the intermediate layers from a paste-form bonding material, for example, leads to more reliable bond between the electrodes and the thermoelectric elements. Further, with the paste-form bonding material, the intermediate layers can be easily formed only by applying it between the electrodes and the thermoelectric elements. The handling of the material is therefore easy, leading to improved work efficiency in the manufacture of the thermoelectric module.

Use of powder of a metal having high diffusivity, for example, leads to enhanced bond strength between the electrodes and the thermoelectric elements.

Metals such as copper and nickel have high diffusivity as well as good electric conductivity. Thus, powder of copper or nickel is suited to be contained in the intermediate layers to compensate for variations in height of the thermoelectric elements and achieve high bond strength.

### Brief Description of the Drawings

FIG. 1 is a schematic diagram showing a device for producing a thermoelectric module, used in a method for producing a thermoelectric module according to one embodiment of the present invention, and
FIG. 2 is a diagram showing part A of FIG. 1 on a magnified scale.

### Mode for Carrying out the Invention

With reference to the drawings attached, an embodiment of the present invention will be described below.

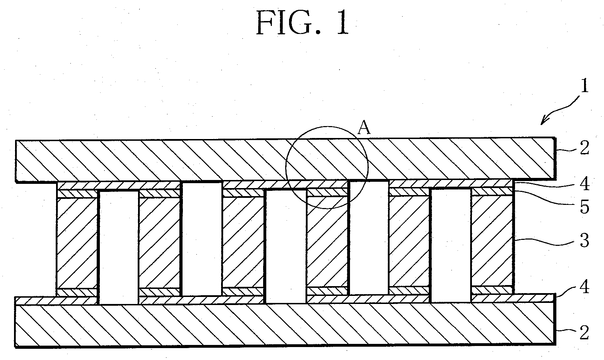

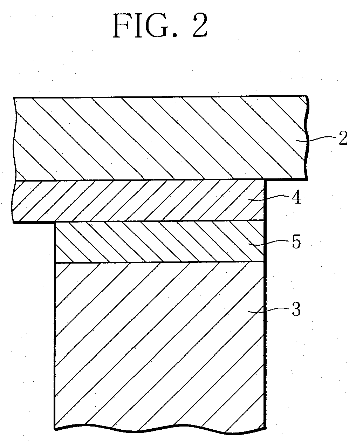

FIG. 1 is a schematic diagram showing a device for producing a thermoelectric module, used in a method for producing a thermoelectric module according to one embodiment of the present invention. FIG. 2 is a diagram showing part A of FIG. 1 on a magnified scale.

As seen in the drawings, a device 1 for producing a thermoelectric module comprises a pair of vertically-arranged punches 2, which correspond to current-supplying/pressing members. The punches 2 are made of an electroconductive material (graphite, for example). Between the punches 2, a plurality of thermoelectric elements 3 (six thermoelectric elements 3 in the depicted example) are arranged.

Specifically, p-type and n-type thermoelectric elements 3 are arranged alternately. Alternatively, each thermoelectric element 3 may be a p-n junction type thermoelectric element, and, in this case, any two adjacent thermoelectric elements 3 are arranged in such manner that the n-type side of one of the thermoelectric elements 3 and the p-type side of another of the thermoelectric elements 3 are associated with one electrode 4. In other words, the p-n junction type thermoelectric elements 3 are arranged in such manner that any two adjacent thermoelectric elements 3 have an opposite polarity.

The thermoelectric elements 3 each measure 2 mm in diameter and 5 to 10 mm in length, for example, and 25 of such thermoelectric elements 3 are arranged in an array of 5 rows and 5 columns, for example (in FIG. 1, six thermoelectric elements are arranged in one row, for illustrative purposes). The punches 2 are each square in cross-section, and measure 35 to 40 mm on one side and 5 to 6 mm in thickness, for example.

Any two adjacent thermoelectric elements 3 are connected by one electrode 4. More specifically, the thermoelectric elements 3 are connected in series in the manner that any thermoelectric element 3 having an adjacent thermoelectric element 3 on either side is connected to one of the adjacent thermoelectric elements 3 at the top by an electrode 4 and to the other at the bottom by another electrode 4. The electrodes 4 are made of copper, for example.

Between each thermoelectric element 3 and its associated electrode 4 is provided an intermediate layer 5. The intermediate layer 5 contains an electroconductive metal powder, and has plasticity, and thus is deformable. The intermediate layer 5 can therefore be deformed, or squashed by pressing with the punches 2. The intermediate layer 5 measures about 10 µm thick.

In the manufacture of a thermoelectric module, electrodes 4 are positioned on a pair of punches 2 arranged to face each other, at their surfaces facing each other, and the thermoelectric elements 3 are arranged in the above-described alternate order. Intermediate layers 5 are formed between the thermoelectric elements 3 and the electrodes 4. Then, diffusion bonding (plasma bonding) of the thermoelectric elements 3 and the electrodes 4 is conducted by supplying an electric current to pass through the electrodes 4 and the thermoelectric elements 3 while pressing the electrodes 4 and the thermoelectric elements 3 by means of the punches 2 arranged on both sides thereof. As a result, a thermoelectric module is obtained. Such supply of an electric current and application of pressure is conducted in a vacuum or an atmosphere of nitrogen gas or an inert gas inside a chamber (not shown).

If the thermoelectric elements 3 have variations in height, the intermediate layers 5 thus provided compensate for such variations by each deforming according to the size of a gap between its associated electrode 4 and thermoelectric element 3. Specifically, the intermediate layer 5 between a relatively low thermoelectric element 3 and an electrode 4 remains unchanged after receiving pressure applied with the punches 2, while the intermediate layer 5 between a relatively high thermoelectric element 3 and an electrode 4 is deformed, or squashed by pressure applied with the punches 2. Thus, by virtue of the intermediate layers 5, all the thermoelectric elements 3 are uniformly bonded to the associated electrodes 4, so that the thermoelectric module 4 obtained has stable thermoelectric properties. The intermediate layers 5 contains metal powder and therefore it can provide good electric conductivity between the electrodes 4 and the thermoelectric elements 3. Consequently, the manufacture of the thermoelectric transformer by supplying an electric current and applying pressure can be conducted without problems. It is noted that the intermediate layers may be provided at both ends or either end of the respective thermoelectric elements 3.

The intermediate layers 3 may be formed from a paste-form material, specifically, a paste-form bonding material prepared by adding an organic binder, such as epoxy resin, to metal powder. By virtue of the bonding ability of such material, the electrodes 4 and the thermoelectric elements 3 are reliably bonded. In this case, the intermediate layers 5 can be formed only by applying the paste-form bonding material. The handling of the material is therefore easy, leading to improved work efficiency in the manufacture of the thermoelectric module.

Desirably, the metal powder contained in the intermediate layers 5 is powder of a metal having high diffusivity. In the bonding of the thermoelectric elements 3 and the electrodes 4 by supplying an electric current and applying pressure in the above-described manner, mutual diffusion of ingredients across the interface between the thermoelectric elements 3 and their associated electrodes 4 occurs, so that alloys are formed, and thereby, the thermoelectric elements 3 are bonded to their associated electrodes 4. Thus, higher diffusivity results in higher strength of bond between the electrodes and the thermoelectric elements.

Desirably, the metal powder is powder of copper (Cu) or nickel (Ni). These metals have high diffusivity as well as good electric conductivity, and thus are suitable to produce the aforementioned effects (absorb height variations and enhance bond strength).

### Explanation of Reference Characters

1: Device for producing a thermoelectric module
2: Punch
3: Thermoelectric element
4: Electrode
5: Intermediate layer

## Claims

1. A method for producing a thermoelectric module, comprising steps of
positioning electrodes (4) on a pair of current-supplying/pressing members arranged to face each other, at their surfaces facing each other;
arranging a plurality of thermoelectric elements (3) to be interposed between the electrodes (4); and
bonding the thermoelectric elements (3) and the electrodes (4) by supplying an electric current to pass through the electrodes (4) and the thermoelectric elements (3) while pressing the electrodes (4) and the thermoelectric elements (3) by means of the current-supplying/pressing members,
**characterized in that**
the method further comprises a step of forming a paste-form intermediate layer (5) containing an electroconductive metal powder and having elasticity, before supplying the electric current to pass through the electrodes (4) and the thermoelectric elements (3), between each of the electrodes (4) and the thermoelectric element (3) to be bonded thereto, thereby compensating variations in height of the thermoelectric elements (3).

2. The method for producing a thermoelectric module according to claim 1, wherein the intermediate layer (5) is made from a paste-form bonding material containing the metal powder.

3. The method for producing a thermoelectric module, according to claim 1, wherein the metal powder is powder of copper or nickel.

## Patentansprüche

1. Verfahren zur Herstellung eines thermoelektrischen Moduls, wobei das Verfahren die folgenden Schritte umfasst:
Positionieren von Elektroden (4) auf einander zugewandten Flächen eines Paars von einander zugewandt angeordneten Stromversorgungs-/Anpressgliedern;
Anordnen einer Vielzahl von thermoelektrischen Elementen (3), derart, dass diese zwischen den Elektroden (4) angeordnet sind; und
Verbinden der thermoelektrischen Elemente (3) und der Elektroden (4) durch Zuführten eines elektrischen Stroms, der durch die Elektroden (4) und die thermoelektrischen Elemente (3) fließt, während die Elektroden (4) und die thermoelektrischen Elemente (3) mittels der Stromversorgungs-/Anpressglieder mit einem Anpressdruck beaufschlagt werden,
**dadurch gekennzeichnet,**
**dass** das Verfahren vor dem Zuführen des durch die Elektroden (4) und die thermoelektrischen Elemente (3) fließenden elektrischen Stroms des Weiteren einen Schritt des Ausbildens einer ein elektrisch leitfähiges Metallpulver enthaltenden und Elastizität aufweisenden pastenförmigen Zwischenschicht (5) zwischen den jeweiligen Elektroden (4) und dem mit diesen zu verbindenden thermoelektrischen Element (3) umfasst, wodurch Höhenschwankungen der thermoelektrischen Elemente (3) ausgeglichen werden.

2. Verfahren zur Herstellung eines thermoelektrischen Moduls nach Anspruch 1, wobei die Zwischenschicht (5) aus einem das Metallpulver enthaltenden pastenförmigen Bondmaterial ausgebildet ist.

3. Verfahren zur Herstellung eines thermoelektrischen Moduls nach Anspruch 1, wobei das Metallpulver ein Pulver aus Kupfer oder Nickel ist.

## Revendications

1. Procédé de production d'un module thermoélectrique, comprenant des étapes de :
positionner des électrodes (4) sur des surfaces se faisant face l'une à l'autre d'une paire d'éléments d'application de courant/pression disposés de manière à se faire face l'un à l'autre ;
disposer une pluralité d'éléments thermoélectriques (3) de manière à être interposés entre les électrodes (4) ; et
lier les éléments thermoélectriques (3) et les électrodes (4) en appliquant un courant électrique de manière à passer à travers les électrodes (4) et les éléments thermoélectriques (3) tout en pressant les électrodes (4) et les éléments thermoélectriques (3) au moyen des éléments d'application de courant/pression,
**caractérisé en ce que**
le procédé comprend en outre une étape de former une couche intermédiaire (5) sous forme de pâte contenant une poudre métallique électro conductrice et ayant de l'élasticité, avant d'appliquer le courant électrique de manière à passer à travers les électrodes (4) et les éléments thermoélectriques (3), entre chacune des électrodes (4) et l'élément thermoélectrique (3) destiné à être lier à celle-ci, compensant ainsi des variations de hauteur des éléments thermoélectrique (3).

2. Procédé de production d'un module thermoélectrique selon la revendication 1, dans lequel la couche intermédiaire (5) est faite à partir d'un matériau de liaison sous forme de pâte contenant la poudre métallique.

3. Procédé de production d'un module thermoélectrique selon la revendication 1, dans lequel la poudre métallique est une poudre de cuivre ou de nickel.
